# EUROPEAN PATENT APPLICATION

(11) **EP 4 436 321 A1**
(43) Date of publication of application: **25.09.2024**
(21) Application number: 22914059.5
(22) Date of filing: 05.12.2022
(51) Int. Cl.: H05K 1/14

(54) **CIRCUIT BOARD ASSEMBLY AND ELECTRONIC DEVICE**

(30) Priority: 30.12.2021 CN 202111645822
(71) Applicant: Huawei Technologies Co., Ltd., Shenzhen, Guangdong 518129 (CN)
(72) Inventor: ZHANG, Tong, Shenzhen, Guangdong 518129 (CN); JIANG, Fan, Shenzhen, Guangdong 518129 (CN); TANG, Heyujia, Shenzhen, Guangdong 518129 (CN); ZHOU, Haisheng, Shenzhen, Guangdong 518129 (CN); WEI, Dan, Shenzhen, Guangdong 518129 (CN); LI, Kelin, Shenzhen, Guangdong 518129 (CN); LI, Jiguang, Shenzhen, Guangdong 518129 (CN); WANG, Hao, Shenzhen, Guangdong 518129 (CN)
(74) Representative: Gill Jennings & Every LLP
(86) International application number: PCT/CN2022/136576
(87) International publication number: WO 2023/124804

(57) **Abstract**

This application provides a circuit board assembly and an electronic device, where the circuit board assembly includes a first circuit board and a second circuit board. The first circuit board is a flexible printed circuit, and a stiffener and one or more first pads are disposed on a first surface of the first circuit board. The stiffener is provided with first through holes, at least one first pad is located in the first through hole, and hardness of the stiffener is greater than hardness of the first circuit board. In addition, second pads are disposed on the second circuit board, and the at least one first pad is soldered to the second pad, to implement an electrical connection between the first circuit board and the second circuit board. The stiffener with large hardness is disposed, by using the circuit board assembly provided in this application, on the first circuit board, which can help improve structural strength and flatness of a region that is of the first circuit board and in which the stiffener is disposed. In this way, reliability of soldering between the first pads and the second pads can be improved, so that reliability of the connection between the first circuit board and the second circuit board is improved.

## Description

### CROSS-REFERENCE TO RELATED APPLICATIONS

This application claims priority to Chinese Patent Application No. 202111645822.1, filed with the China National Intellectual Property Administration on December 30, 2021, and entitled "CIRCUIT BOARD ASSEMBLY AND ELECTRONIC DEVICE", which is incorporated herein by reference in its entirety.

### TECHNICAL FIELD

This application relates to the field of electronic device technologies, and in particular, to a circuit board assembly and an electronic device.

### BACKGROUND

Currently, electronic devices such as a mobile phone, a tablet, and a wearable product are developing rapidly. A printed circuit board (printed circuit board, PCB) and a flexible printed circuit (flexible printed circuit, FPC) are widely used in these electronic devices.

In some application scenarios, to implement a function of the electronic device, the PCB needs to be electrically connected to the FPC. An FPC on board (FPC on board, FOB) technology may implement an electrical connection between the FPC and the PCB by soldering corresponding pads of the FPC and the PCB to each other. Currently, commonly used FPC on board technologies may include: a board to board (board to board, BTB) connector solution, an anisotropic conductive film (anisotropic conductive film, ACF) process, and a hotbar (hotbar) soldering process. However, the currently used FPC on board technologies generally have problems such as too large layout space and poor connection reliability.

Based on this, providing an inter-board interconnection solution that helps improve reliability of an inter-board connection has become a difficult problem to be urgently resolved by persons skilled in the art.

### SUMMARY

This application provides a circuit board assembly and an electronic device, to help improve reliability of a connection between circuit boards in the circuit board assembly.

According to a first aspect, this application provides a circuit board assembly, where the circuit board assembly includes a first circuit board and a second circuit board. The first circuit board is a flexible printed circuit. A stiffener and first pads are disposed on a first surface of the first circuit board. The stiffener is provided with first through holes, at least one first pad is located in the first through hole, and hardness of the stiffener is greater than hardness of the first circuit board. In addition, second pads are disposed on the second circuit board, and the at least one first pad is soldered to the second pad, to implement an electrical connection between the first circuit board and the second circuit board. The stiffener with large hardness is disposed, by using the circuit board assembly, in a region that is of the first circuit board and that corresponds to the first pads, so that structural strength and flatness of the region that is of the first circuit board and in which the stiffener is disposed can be improved. In this way, reliability of soldering between the first pads and the second pads can be improved, so that reliability of the connection between the first circuit board and the second circuit board is improved.

In addition, because the hardness of the stiffener is greater than the hardness of the first circuit board, when the first circuit board is soldered to the second circuit board, the stiffener may press the first pads to the corresponding second pads thereby improving the reliability of the soldering between the first pads and the second pads. In addition, in this application, the stiffener with large hardness is disposed on the first circuit board, to improve structural strength and flatness of the first circuit board. In this way, the first circuit board and another component may be soldered to the second circuit board by using a same process, which helps reduce processing processes of the circuit board assembly, thereby improving processing efficiency, and reducing processing costs. In addition, in a case in which function implementation of the first circuit board and function implementation of the another component do not affect each other, a distance between the first circuit board and the another component may be short, to facilitate implementation of a miniaturization design of the circuit board assembly.

In this application, a material of the stiffener is not limited. For example, the stiffener may be glass fiber, polyimide, or stainless steel. In this way, the structural strength and the flatness of the region that is of the first circuit board and in which the stiffener is disposed can be effectively improved.

Specifically, when the first circuit board is disposed, surfaces of the first circuit board may include the first surface and a second surface that are disposed back to each other. At least two first pads may be disposed on the first surface, and at least two first pads are also disposed on the second surface. The at least two first pads on the first surface are disposed in a one-to-one correspondence with the at least two first pads on the second surface, and the first pads on the first surface and the first pads on the second surface that are correspondingly disposed are connected through second through holes.

In a possible implementation of this application, the first surface may be a surface that is of the first circuit board and that faces the second circuit board. In this way, in a process of soldering the first pads of the first surface to the second pads, solders between the first pads and the second pads can overflow from the first surface to the first pads of the second surface through the second through holes, thereby reducing an amount of solders overflowing to another surrounding pad, and reducing a risk of a short circuit between pads.

In addition, it should be noted that the at least two first pads on the first surface may be located in the first through holes of the stiffener, to solder the first pads to the corresponding second pads. It should be noted that the stiffener may be provided with at least two first through holes, and each first pad is located in one first through hole in a one-to-one correspondence, so that in a process of soldering the first pads to the second pads, the first through holes can block solder overflow, thereby effectively avoiding the short circuit between the pads. Alternatively, the stiffener is provided with at least one first through hole. In this case, the at least two first pads may be located in one first through hole. In other words, at least two first pads may be accommodated in each first through hole. According to this solution, a manufacturing process of the stiffener may be simplified, and structural strength of the stiffener may be improved.

In addition, because the first surface of the first circuit board is disposed facing the second circuit board, in a possible implementation, the stiffener may abut against the second circuit board, so that the first through holes of the stiffener can block the solder more effectively. In addition, the stiffener may further support the first circuit board, thereby improving structural strength of the first circuit board.

In another possible implementation of this application, the first surface may be a surface that is of the first circuit board and that is opposite to the second circuit board. In this implementation, the at least two first pads on the first surface may be located in the first through holes of the stiffener. In this way, in a process of soldering the first circuit board to the second circuit board, a case in which the solder overflows from the first surface to the second surface may be checked by using the first through holes, to determine reliability of soldering between the first pads of the first surface and the second pads. This helps improve a product yield rate of the circuit board assembly. In addition, in this implementation, the first through holes can also block solder overflow, to reduce a risk of a short circuit between pads.

It should be noted that, in this implementation, the first pads located in the first through holes may be soldered to the second pads via a solder that passes through the second through holes.

In addition, in this implementation, the circuit board assembly may further include a gasket, and the gasket may be located between the first circuit board and the second circuit board. In addition, the gasket may separately abut against the first circuit board and the second circuit board, to avoid a short circuit between adjacent pads caused by solder overflow between the first pads and the second pads that are correspondingly soldered.

When the first surface is disposed opposite to the second circuit board, at least two first pads may be disposed on the first surface, and the stiffener may be provided with at least two first through holes, so that each first pad may be located in one first through hole in a one-to-one correspondence, thereby effectively avoiding the short circuit between the pads. Alternatively, the stiffener is provided with at least one first through hole. In this case, the at least two first pads may be located in one first through hole. In other words, at least two first pads may be accommodated in each first through hole. According to this solution, a manufacturing process of the stiffener may be simplified, and structural strength of the stiffener may be improved.

In addition, a height of the stiffener from the surface of the first circuit board is greater than or equal to a first height, and the first height is a height of the first pad disposed on a same surface as the first circuit board from the first surface of the first circuit board. Therefore, the first through holes of the stiffener can block the solder more effectively, to reduce a risk of the short circuit between the pads.

In addition to the foregoing disposition manner, in a possible implementation of this application, the first circuit board may include the first surface and the second surface that are disposed back to each other, and the first surface is a surface that is of the first circuit board and that is disposed facing the second circuit board. In this implementation, the first pads are disposed on the first surface, and no first pad is disposed on the second surface. In addition, the stiffener may be disposed on the first surface, and the at least one first pad on the first surface may be located in the first through hole of the stiffener, to solder the first pad to the corresponding second pad. It should be noted that at least two first pads may be on the first surface, and the stiffener may be provided with at least two first through holes. In this way, each first pad is located in one first through hole in a one-to-one correspondence, so that in a process of soldering the first pads to the second pads, the first through holes can block solder overflow. Alternatively, the stiffener is provided with at least one first through hole. In this case, the at least two first pads may be located in one first through hole. In other words, at least two first pads may be accommodated in each first through hole. According to this solution, a manufacturing process of the stiffener may be simplified, and structural strength of the stiffener may be improved.

Because the first surface of the first circuit board is disposed facing the second circuit board, in this case, the stiffener may abut against the second circuit board, so that the first through holes of the stiffener can block the solder more effectively. In addition, the stiffener may further support the first circuit board, thereby improving structural strength of the first circuit board.

According to a second aspect, this application further provides a circuit board assembly, where the circuit board assembly includes a first circuit board, a second circuit board, and a gasket. The first circuit board is a flexible printed circuit, first pads are disposed on a first surface of the first circuit board, a stiffener is disposed on a second surface of the first circuit board, the first surface and the second surface are disposed back to each other, and hardness of the stiffener is greater than hardness of the first circuit board. In addition, the first pads are disposed on the first surface of the first circuit board, and no first pad is disposed on the second surface. In this way, the stiffener may be a continuous plate structure, which can effectively improve structural strength and flatness of a region that is of the first circuit board and in which the stiffener is disposed. Because the stiffener is disposed in the region that is on the first circuit board and that corresponds to the pads, using the circuit board assembly may help improve reliability of soldering between the first pads and the second pads, thereby improving reliability of a connection between the first circuit board and the second circuit board.

In addition, the gasket may be located between the first circuit board and the second circuit board, and the gasket may separately abut against the first circuit board and the second circuit board, to avoid a short circuit between adjacent pads caused by solder overflow between the first pads and the second pads that are correspondingly soldered to each other.

In this application, the gasket may be disposed on the first circuit board, or may be disposed on the second circuit board. For example, in a possible implementation of this application, the gasket is disposed on the second circuit board, and the gasket and the second pads are disposed on a same surface of the second circuit board. In addition, a height of the gasket from the surface of the second circuit board is greater than a height of the second pad from the surface of the second circuit board, so that the gasket can abut against the first surface of the first circuit board. In this way, a distance between the first pad and the second pad that are correspondingly soldered to each other may be increased by adjusting a height of the gasket, so that in a process of soldering the first circuit board to the second circuit board, an amount of solders that are between the first pads and the second pads and that overflow to another pad can be reduced, thereby effectively avoiding a short circuit between adjacent pads.

Specifically, when the gasket is disposed, the gasket may be, but is not limited to, an annular structure, and at least one second pad in a second soldering region of the second circuit board may be disposed in a closed region enclosed by the gasket. Alternatively, the gasket may have a plurality of segments, and the plurality of segments of the gasket are disposed at gaps between adjacent second pads or corners of the second soldering region provided that the gasket can be used to increase the distance between the first pad and the second pad that are correspondingly soldered to each other.

It can be learned from the foregoing description of the gasket that the gasket may be disposed to increase a distance between the first circuit board and the second circuit board, thereby reducing a risk of the short circuit between the pads. Based on this, in addition to being disposed on the second circuit board, in another possible implementation of this application, the gasket may be further disposed on the first circuit board. Because the first surface of the first circuit board is disposed opposite to the second circuit board, the gasket may be disposed on the first surface of the first circuit board. In addition, a height of the gasket from the first surface is greater than a height of the first pad from the first surface, and the gasket abuts against the second circuit board. In this case, the distance between the first pad and the second pad that are correspondingly soldered to each other may be increased by adjusting the height of the gasket, so that in the process of soldering the first circuit board to the second circuit board, the amount of the solders that are between the first pads and the second pads and that overflow to another pad can be reduced, thereby effectively avoiding the short circuit between the adjacent pads.

It should be noted that, in this implementation solution of this application, a material of the stiffener is not limited, and may be, for example, glass fiber, polyimide, or stainless steel. In this way, structural strength and flatness of a region that is of the first circuit board and in which the stiffener is disposed can be effectively improved.

According to a third aspect, this application further provides a soldering method of the circuit board assembly according to the first aspect and/or the second aspect, where the soldering method may include:
moving a first circuit board to a second circuit board, and disposing first pads corresponding to second pads; and
soldering the first pads to the second pads, where the first pads and the second pads are correspondingly disposed.

When the first circuit board and the second circuit board are soldered to each other by using the soldering method, because a stiffener is disposed on the first circuit board, the stiffener may improve structural strength and flatness of a first soldering region of the first circuit board, and may press the first pads to the correspondingly disposed second pads, thereby improving reliability of soldering between the two pads. In addition, in this application, the first circuit board may be used as a component, and is soldered to the second circuit board by using a same process with another component, which helps reduce processing processes of the circuit board assembly, thereby improving processing efficiency, and reducing processing costs. In addition, in a case in which function implementation of the first circuit board and function implementation of the another component do not affect each other, a distance between the first circuit board and the another component may be short, to facilitate implementation of a miniaturization design of the circuit board assembly.

In a possible implementation of this application, the soldering the first pads to the second pads, where the first pads and the second pads are correspondingly disposed may specifically include: soldering, by using reflow soldering, the first pads to the second pads, where the first pads and the second pads are correspondingly disposed. In this way, in a process of soldering the first pads to the second pads, where the first pads and the second pads are correspondingly disposed, damage to components on the first circuit board and the second circuit board may be avoided, and the first circuit board and another component may be conveniently soldered to the second circuit board by using a same process, thereby improving processing efficiency and reducing processing costs.

In a possible implementation of this application, before the moving a first circuit board to a second circuit board, the soldering method may further include: placing a solder on the second pads of the second circuit board. The solder may be but is not limited to solder paste. In addition, placement of the solder may be implemented via, but is not limited to, screen printing or a solder spraying technology.

According to a fourth aspect, this application provides an electronic device. The electronic device includes the circuit board assembly in the first aspect. In the electronic device provided in this application, because a volume of the circuit board assembly may be small, space occupied by the circuit board assembly in the electronic device is small. In this way, a miniaturization design of the electronic device can be implemented. In addition, space may be further reserved for setting another function module in the electronic device, to facilitate diversification of functions of the electronic device.

### BRIEF DESCRIPTION OF DRAWINGS

FIG. 1a is a schematic diagram of a structure of a circuit board assembly connected through a BTB connector according to an embodiment of this application;
FIG. 1b is a schematic diagram of a structure of a circuit board assembly connected through an ACF process according to an embodiment of this application;
FIG. 1c is a schematic diagram of a structure of a circuit board assembly connected through a hotbar soldering process according to an embodiment of this application;
FIG. 2 is a schematic diagram of a structure of a circuit board assembly according to an embodiment of this application;
FIG. 3a is a schematic diagram of a structure of a first surface of a first circuit board according to an embodiment of this application;
FIG. 3b is a schematic diagram of a structure of a second surface of a first circuit board according to an embodiment of this application;
FIG. 4 is a sectional view of an A-A part in FIG. 3b;
FIG. 5 is a B-direction view of a partial structure of a first circuit board shown in FIG. 4;
FIG. 6 is a schematic diagram of a structure of a second circuit board according to an embodiment of this application;
FIG. 7a to FIG. 7c are process flow diagrams of soldering a first circuit board and a second circuit board according to an embodiment of this application;
FIG. 8 is a sectional view of a circuit board assembly according to an embodiment of this application;
FIG. 9 is a schematic diagram of a structure of a circuit board assembly according to another embodiment of this application;
FIG. 10 is a sectional view of a C-C part in FIG. 9;
FIG. 11 is a schematic diagram of a structure of a circuit board assembly according to another embodiment of this application;
FIG. 12 is a schematic diagram of a structure of a first circuit board of the circuit board assembly shown in FIG. 11;
FIG. 13 is a sectional view of a D-D part in FIG. 12;
FIG. 14 is a sectional view of an E-E part in FIG. 11;
FIG. 15 is a schematic diagram of a structure of a circuit board assembly according to another embodiment of this application;
FIG. 16 is a schematic diagram of a structure of a first circuit board of the circuit board assembly shown in FIG. 15;
FIG. 17 is a sectional view of an F-F part in FIG. 16;
FIG. 18 is a sectional view of a G-G part in FIG. 15;
FIG. 19 is a schematic diagram of a structure of a second circuit board according to another embodiment of this application;
FIG. 20 is a sectional view of an H-H part in FIG. 19; and
FIG. 21 is a sectional view of a partial structure of a circuit board assembly according to another embodiment of this application.

### Reference numerals:

1101: printed circuit board; 11011: first pad; 1102: flexible printed circuit; 11021: second pad;
1103: first BTB connector; 1104: second BTB connector; 1105: anisotropic conductive film; 1106: solder;
1107: thermal head;
1: first circuit board; 1a: first surface; 1b: second surface; 101: first soldering region; 102a and 102b: first pad;
1021: second through hole; 103: stiffener; 1031: first through hole; 2: second circuit board; 201: second soldering region;
202: second pad; 3: solder; and 4: gasket.

### DESCRIPTION OF EMBODIMENTS

Terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment" or "a specific embodiment" or the like described in the specification means that one or more embodiments of this application include a specific feature, structure, or characteristic described with reference to this embodiment. The terms "include", "comprise", "have", and their variants all mean "include but is not limited to", unless otherwise specifically emphasized.

To facilitate understanding of a circuit board assembly provided in an embodiment of this application, an application scenario of the circuit board assembly is first described below. The circuit board assembly may be applied to various electronic devices. For example, the circuit board assembly may be but is not limited to a digital display product like a mobile phone, a tablet computer (pad), a portable game console, a personal digital assistant (personal digital assistant, PDA), a notebook computer, an ultra-mobile personal computer (ultra-mobile personal computer, UMPC), a handheld computer, a netbook, a vehicle-mounted media player, a wearable electronic device, a virtual reality (virtual reality, VR) terminal device, and an augmented reality (augmented reality, AR) terminal device.

The circuit board assembly may generally include at least two circuit boards, and the at least two circuit boards may be electrically connected in a direct or indirect manner, so that a function of a single circuit board is extended. In addition, the at least two circuit boards may be printed circuit boards, or may be flexible printed circuits. To enable the circuit board assembly to implement functions of the circuit board assembly and facilitate installation of the circuit board assembly in the electronic device, generally, at least one circuit board in the circuit board assembly may be a printed circuit board, and at least another circuit board is a flexible printed circuit.

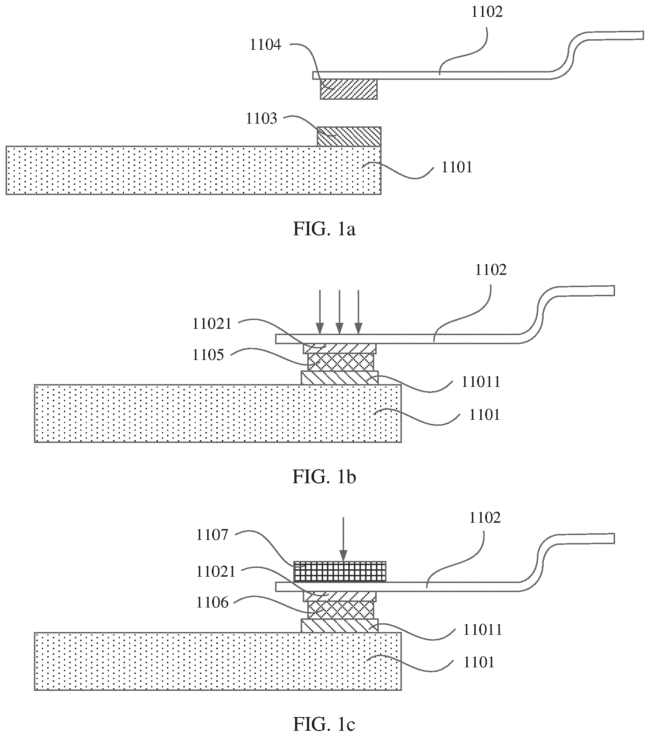

Because a plurality of pads may be disposed on a surface of either the printed circuit board or the flexible printed circuit, the pads may be electrically connected to a component on the circuit board through a cable disposed inside the circuit board. Based on this, an electrical connection between the printed circuit board and the flexible printed circuit may be implemented by soldering corresponding pads. Currently, interconnection between circuit boards may be implemented through a BTB connector, an ACF process, a hotbar soldering process, and the like. When circuit boards are interconnected through the BTB connector, refer to FIG. 1a. In FIG. 1a, a connection between a printed circuit board 1101 and a flexible printed circuit 1102 is used as an example, and a solution in which circuit boards are connected through the BTB connector is illustrated. In this solution, a first BTB connector 1103 is disposed on the printed circuit board 1101, and the first BTB connector 1103 may be electrically connected to pads (not shown in FIG. 1a) on the printed circuit board 1101. In addition, a second BTB connector 1104 is disposed on the flexible printed circuit 1102, and the second BTB connector 1104 may be electrically connected to pads (not shown in FIG. 1a) on the flexible printed circuit 1102. In this way, the first BTB connector 1103 and the second BTB connector 1104 may be mechanically fastened, so that the two BTB connectors are electrically connected, thereby implementing an electrical connection between the printed circuit board 1101 and the flexible printed circuit 1102. However, because a size of the BTB connector is usually large, limited by the size of the BTB connector, it is not conducive to implementing a miniaturization design of the circuit board assembly.

For the ACF process, refer to FIG. 1b. FIG. 1b is a schematic diagram in which the printed circuit board 1101 is connected to the flexible printed circuit 1102 by using the ACF process. In this solution, an anisotropic conductive film 1105 may be disposed between first pads 11011 of the printed circuit board 1101 and second pads 11021 of the flexible printed circuit 1102, and then the anisotropic conductive film 1105 is electrically connected to the two circuit boards in a hot pressing manner, to implement conduction between the two circuit boards. As a result, no component can be disposed in hot pressing regions of the printed circuit board 1101 and the flexible printed circuit 1102 and projection regions of the hot pressing regions on the printed circuit board 1101 and the flexible printed circuit 1102. Therefore, layout space of a connection region between the printed circuit board 1101 and the flexible printed circuit 1102 is large, which is not conducive to implementing the miniaturization design of the circuit board assembly. In addition, when the printed circuit board 1101 is connected to the flexible printed circuit 1102 by using the ACF process, reliability of the connection is poor, and maintenance is difficult.

In addition, FIG. 1c is a schematic diagram in which the printed circuit board 1101 and the flexible printed circuit 1102 are soldered to each other by using the hotbar soldering process. In this solution, a solder 1106 may be disposed between first pads 11011 of the printed circuit board 1101 and second pads 11021 of the flexible printed circuit 1102, and then the solder 1106 is heated by using a thermal head 1107, to implement conduction between corresponding pads. According to this solution, no component can be disposed in heating regions of the two circuit boards and projection regions of the heating regions on the two circuit boards. Therefore, the layout space of the connection region between the printed circuit board 1101 and the flexible printed circuit 1102 is large, which is not conducive to implementing the miniaturization design of the circuit board assembly.

The circuit board assembly provided in this application is intended to resolve the foregoing problems, to implement the miniaturization design of the circuit board assembly, and further optimize the connection between circuit boards of the circuit board assembly from existing independent station processing to same process processing with another component, thereby achieving objectives of simplifying processing processes, improving processing efficiency, and reducing processing costs. To make the objectives, technical solutions, and advantages of this application clearer, the following further describes this application in detail with reference to the accompanying drawings.

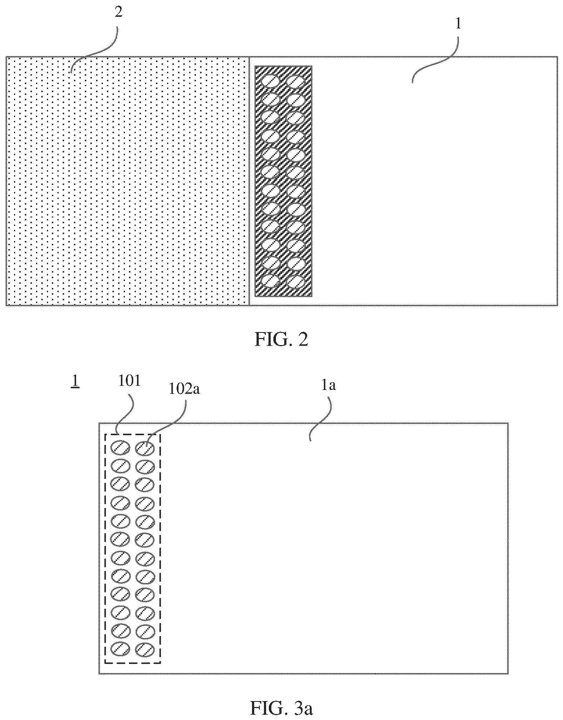

First, FIG. 2 is a schematic diagram of a structure of a circuit board assembly according to a possible embodiment of this application. The circuit board assembly provided in this application may include at least two circuit boards, and may include, for example, a first circuit board 1 and a second circuit board 2. The first circuit board 1 is a flexible printed circuit, and the first circuit board 1 is electrically connected to the second circuit board 2.

Specifically, when the first circuit board is disposed, the first circuit board 1 may include two surfaces that are disposed back to each other. FIG. 3a is a schematic diagram of a structure of a surface 1a of the first circuit board 1. The surface 1a may be a surface that is of the first circuit board 1 and that faces the second circuit board 2 shown in FIG. 2. In other words, the surface 1a is a surface that is of the first circuit board 1 and that is used for soldering to the second circuit board 2. Therefore, the surface 1a may be referred to as a soldering surface. In addition, in this application, the first circuit board 1 has a first soldering region 101, and the first soldering region 101 is a region that is of the first circuit board 1 and that is used for soldering to the second circuit board 2. It may be understood that a dashed box in FIG. 1a is merely an example of a manner of disposing the first soldering region 101. The first soldering region 101 may be, but is not limited to, located at an end of the first circuit board 1, to solder the first circuit board 1 to the second circuit board 2. In addition, only one first soldering region 101 may be disposed on the first circuit board 1, or a plurality of first soldering regions 101 may be disposed on the first circuit board 1, which may be disposed based on a specific connection status of the first circuit board 1.

Still refer to FIG. 3a. At least two first pads 102a are disposed on the surface 1a of the first circuit board 1, and the at least two first pads 102a are located in the first soldering region 101. In this application, a specific disposition form of the at least two first pads 102a is not limited. For example, the at least two first pads 102a may be ball grid array package (ball grid array package, BGA) pads, or certainly may be pads disposed in any other form.

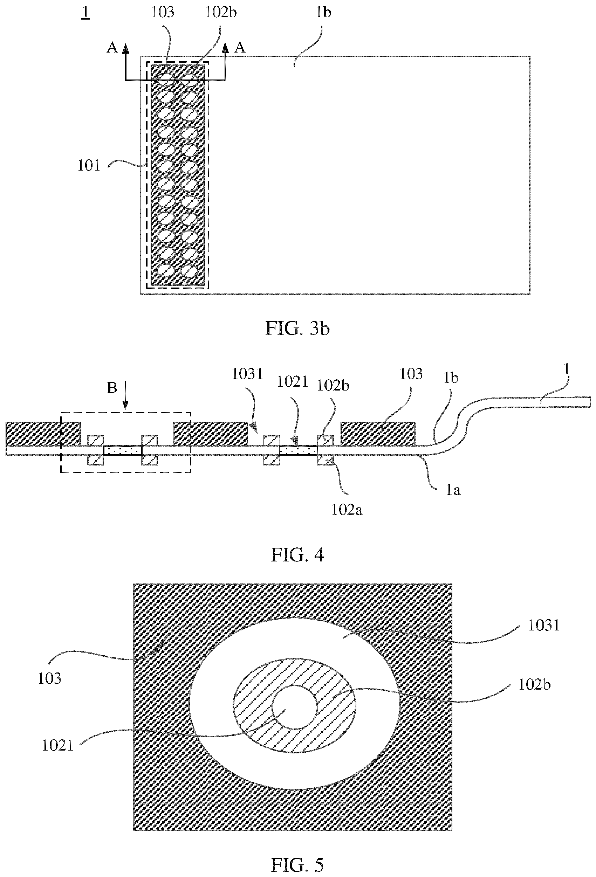

In addition, FIG. 3b is a schematic diagram of a structure of a surface 1b of the first circuit board 1. In this embodiment of this application, at least two first pads 102b may also be disposed on the surface 1b of the first circuit board 1, and the at least two first pads 102b on the surface 1b are also located in the first soldering region 101. In addition, the at least two first pads 102b of the surface 1b may be disposed in a one-to-one correspondence with the at least two first pads 102a of the surface 1a. In other words, each first pad 102b is disposed corresponding to one first pad 102a.

Still refer to FIG. 3b. A stiffener 103 may further be disposed on the first circuit board 1, and the stiffener 103 may be disposed in the first soldering region 101 of the first circuit board 1. Hardness of a material of the stiffener 103 is greater than hardness of a material of the first circuit board 1, so that structural strength of the first soldering region 101 of the first circuit board 1 may be improved by disposing the stiffener 103. In this application, the material of the stiffener 103 is not specifically limited. For example, the stiffener 103 may be glass fiber, polyimide, or stainless steel.

FIG. 4 is a sectional view of an A-A part in FIG. 3b. In this embodiment of this application, the surface 1a may be used as a second surface of the first circuit board 1, and the surface 1b may be used as a first surface of the first circuit board. The stiffener 103 may be disposed on the surface 1b of the first circuit board 1, and the first pads 102b that are also disposed on the surface 1b of the first circuit board 1 may fall within a contour range of the stiffener 103. In addition, the stiffener 103 may be provided with first through holes 1031, and the first pads 102b disposed on the surface 1b may be located in the first through holes 1031. It should be noted that, for example, in an embodiment shown in FIG. 5, FIG. 5 is a B-direction view of a partial structure of the first circuit board 1 shown in FIG. 4. The stiffener 103 may be provided with at least two first through holes 1031, so that each first pad 102b may be located in one first through hole 1031 in a one-to-one correspondence. In some other possible embodiments, the stiffener 103 may be provided with at least one first through hole 1031. In this way, each first pad 102b may be located in one first through hole 1031. In this case, at least one first pad 102b may be disposed in each first through hole 1031. For example, two first pads 102b may be disposed in each first through hole 1031.

It should be noted that the first through hole 1031 of the stiffener 103 is not limited to a circular hole or an elliptical hole shown in FIG. 3b, and a shape of the first through hole 1031 is not specifically limited in this application. In addition, a cross-sectional area of the first through hole 1031 is not limited in this application, provided that the first pad 102b can be accommodated in the corresponding first through hole 1031.

Still refer to FIG. 4 and FIG. 5. In this embodiment of this application, the first pads 102a on the surface 1a of the first circuit board 1 and the first pads 102b on the surface 1b that are correspondingly disposed may be connected to each other through second through holes 1021 that pass through the first circuit board 1.

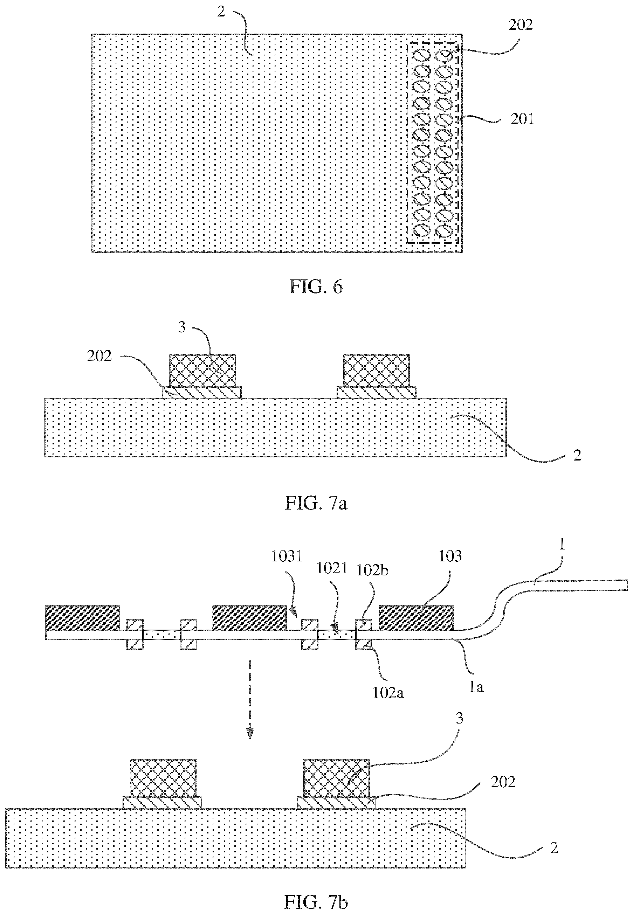

FIG. 6 is a schematic diagram of a structure of a second circuit board 2 according to a possible embodiment of this application. The second circuit board 2 may have a second soldering region 201 used for soldering to the first circuit board 1 shown in FIG. 3a or FIG. 3b. In addition, second pads 202 are disposed on the second circuit board 2, the second pads 202 may be disposed on a surface that is of the second circuit board 2 and that is used for soldering to the first circuit board 1, and the second pads 202 are located in the second soldering region 201. In addition, there may be at least two second pads 202, and the second pads 202 and the first pads 102a that are correspondingly disposed are soldered to each other, so that the first circuit board 1 is electrically connected to the second circuit board 2 through the first pads 102a and the second pads 202 that are soldered to each other.

It should be noted that, in some possible embodiments of this application, a quantity of the second pads 202 on the second circuit board 2 may be the same as a quantity of the first pads 102a on the surface 1a of the first circuit board 1. In this case, the first pads 102a may be soldered to the second pads 202 in a one-to-one correspondence. In some other possible embodiments, a quantity of the second pads 202 on the second circuit board 2 may be different from a quantity of the first pads 102a on the surface 1a of the first circuit board 1. In this case, at least one first pad 102a may be soldered to a corresponding second pad 202, to implement an electrical connection between the first circuit board 1 and the second circuit board 2.

It may be understood that soldering the first pad 102a to the second pad 202 may be implemented by adding a solder 3 between the two pads. During specific implementation, refer to FIG. 7a to FIG. 7c. FIG. 7a to FIG. 7c show a process of soldering the first circuit board 1 to the second circuit board 2 according to a possible embodiment of this application.

First, refer to FIG. 7a. Before the first circuit board 1 is moved to the second circuit board 2, the solder 3 may be placed on the second pads 202 of the second circuit board 2, where the solder 3 may be but is not limited to solder paste. In addition, placement of the solder 3 may be implemented via, but is not limited to, screen printing or a solder spraying technology.

Then, refer to FIG. 7b. The first circuit board 1 may be adsorbed by using adsorbent equipment, and moved to a side that is of the second circuit board 2 and that is used for soldering to the first circuit board 1. In this case, the first pads 102a located on the surface 1a of the first circuit board 1 may be disposed in a one-to-one correspondence with the second pads 202 of the second circuit board 2.

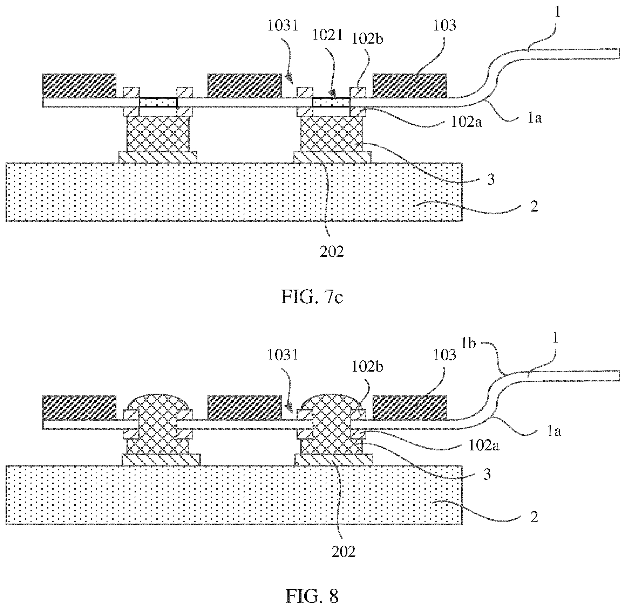

Finally, refer to FIG. 7c. The first circuit board 1 may be placed on top of the second circuit board 2, and each first pad 102a is in contact with the solder 3 of the corresponding second pad 202. In this case, the solder 3 between the first circuit board 1 and the second circuit board 2 may be heated and melted via reflow (reflow) soldering or the like, to solder the first pads 102a to the second pads 202, where the first pads 102a and the second pads 202 are correspondingly disposed.

It can be understood from the foregoing description of the soldering process of the first circuit board 1 and the second circuit board 2 that, because the stiffener 103 is disposed in the first soldering region 101 of the first circuit board 1, for example, shown in FIG. 3a or FIG. 3b, the stiffener 103 can effectively enhance structural strength of the first soldering region 101 of the first circuit board 1, so that the first circuit board 1 can be used as a surface mount component and soldered to the second circuit board 2 by using a surface mount technology (surface mount technology, SMT). Therefore, the first circuit board 1 and another surface mount component may be soldered to the second circuit board 2 by using a same process, which helps reduce processing processes of the circuit board assembly, thereby improving processing efficiency, and reducing processing costs. In addition, on a basis that function implementation of the first circuit board 1 and function implementation of the another component do not affect each other, a distance between the first circuit board 1 and the another component may be as short as possible, to facilitate implementation of a miniaturization design of the circuit board assembly including the first circuit board 1 and the second circuit board 2.

It should be noted that, in this embodiment of this application, both the first pads 102a located on the surface 1a of the first circuit board 1 and the first pads 102b located on the surface 1b of the first circuit board 1 may fall within the contour range of the stiffener 103, so that when the first circuit board 1 is soldered to the second circuit board 2, the first pads 102a disposed on the surface 1a of the first circuit board 1 are enabled to press, under an effect of the stiffener 103, the second circuit board 2, thereby improving reliability of soldering between the first circuit board 1 and the second circuit board 2.

FIG. 8 is a sectional view of a circuit board assembly obtained by using the soldering process shown in FIG. 7a to FIG. 7c. In this embodiment of this application, the first pads 102a on the surface 1a of the first circuit board 1 may be connected to the first pads 102b on the surface 1b through the second through holes 1021. Therefore, in a process of soldering the first circuit board 1 to the second circuit board 2, after the solder 3 between the first pads 102a and the second pads 202 is melted, the solder 3 may overflow from the first pads 102a to the first pads 102b through the second through holes 1021. In this way, a short circuit between the first pads 102a located on the surface 1a of the first circuit board 1 and/or the first pads 102b located on the surface 1b of the first circuit board 1 and the second pads 202 of the second circuit board 2 can be effectively avoided. In addition, the first pads 102b may be soldered to the second pads 202 via the solder 3 that passes through the second through holes 1021.

In addition, in this embodiment of this application, the stiffener 103 is disposed on the surface 1b of the first circuit board 1, the stiffener 103 may be provided with the first through holes 1031, and the first pads 102b are located in the first through holes 1031. In this way, it is convenient to check, by using the first through holes 1031, a case in which the solder 3 overflows to the first pads 102b, so that a soldering effect of the first pads 102a and the second pads 202 that are correspondingly disposed may be determined based on an overflow case. This helps improve a product yield rate of the circuit board assembly. Still refer to FIG. 8. In this embodiment of this application, a height of the stiffener 103 from the surface 1b of the first circuit board 1 may further be greater than or equal to a first height, where the first height is a height of the first pad 102b disposed on a same surface (that is, the surface 1b) as the stiffener 103 from the surface. In this way, a hole wall of the first through holes 1031 of the stiffener 103 can block the solder 3 overflowing to the surface 1b, thereby reducing a risk of a short circuit between adjacent first pads 102b located on the surface 1b.

It should be noted that, based on the circuit board assembly shown in FIG. 8, in some possible embodiments of this application, the circuit board assembly may further include a gasket, and the gasket may separately abut against the first circuit board 1 and the second circuit board 2. In this way, a distance between the first pad 102a and the second pad 202 that are correspondingly soldered to each other may be increased by adjusting a height of the gasket, so that in a process of soldering the first circuit board 1 to the second circuit board 2, an amount of the solder 3 that is between the first pads 102a and the second pads 202 and that overflows to another pad can be reduced, thereby effectively avoiding a short circuit between adjacent pads.

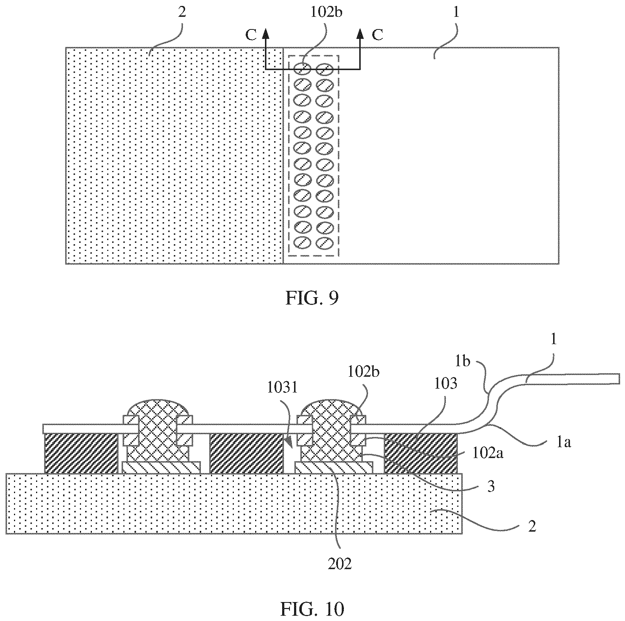

FIG. 9 is a schematic diagram of a structure of a circuit board assembly according to another possible embodiment of this application. In this embodiment, a disposition manner of the circuit board assembly is slightly different from that in the foregoing embodiments, mainly in a disposition position of the stiffener 103 on the first circuit board 1. Specifically, FIG. 10 is a sectional view of a C-C part in FIG. 9.

Still refer to FIG. 10. In this embodiment of this application, the stiffener 103 is disposed on the surface 1a of the first circuit board 1, and the stiffener 103 may be provided with the first through holes 1031. In this case, the first pads 102a on the surface 1a may be located in the first through holes 1031. In addition, in this embodiment, the surface 1a is disposed facing the second circuit board, the surface 1a may be used as a first surface of the first circuit board 1, and the surface 1b may be used as a second surface of the first circuit board 1. A height of the stiffener 103 from the surface 1a may be greater than or equal to a first height, where the first height is a height of the first pad 102a disposed on a same surface (that is, the surface 1a) as the stiffener 103 from the surface, and the stiffener 103 may abut against the second circuit board 2, so that the stiffener 103 can support the first circuit board 1. This helps improve structural strength and flatness of the first circuit board 1.

In the circuit board assembly shown in FIG. 10, the first pads 102a on the surface 1a of the first circuit board 1 may also be connected to the first pads 102b on the surface 1b through second through holes. In this case, according to a design solution of the circuit board assembly, when the first circuit board 1 and the second circuit board 2 are soldered to each other, refer to the foregoing embodiments for a soldering process. Details are not described herein again. It should be noted that, in a process of soldering the first circuit board 1 to the second circuit board 2, the first circuit board 1 and another surface mount component may still be soldered to the second circuit board 2 by using a same process, which helps reduce processing processes of the circuit board assembly, improve processing efficiency, reduce processing costs, and implement a miniaturization design of the circuit board assembly.

In addition, in this embodiment, after the solder 3 between the first pads 102a and the second pads 202 that are correspondingly disposed is melted, the solder 3 also overflows to the surface 1b of the first circuit board 1. Therefore, a case in which the solder 3 overflows to the first pads 102b may be checked, and a soldering effect of the first pads 102 and the second pads 202 that are correspondingly disposed may be determined based on an overflow case, which helps improve the product yield rate of the circuit board assembly.

It should be noted that, in this embodiment of this application, both the first pads 102a located on the surface 1a of the first circuit board 1 and the first pads 102b located on the surface 1b of the first circuit board 1 may fall within the contour range of the stiffener 103, so that when the first circuit board 1 is soldered to the second circuit board 2, the first pads 102a used for soldering to the second circuit board 2 are enabled to press, under an effect of the stiffener 103, the second circuit board 2, thereby improving reliability of soldering between the first circuit board 1 and the second circuit board 2.

In addition, because the stiffener 103 is disposed on the surface 1a, the hole wall of the first through holes 1031 of the stiffener 103 may block overflow of the solder 3 on the surface 1a, thereby reducing a risk of a short circuit between adjacent first pads 102a located on the surface 1a. In addition, a distance between the first pad 102a and the second pad 202 that are correspondingly disposed may be increased by adjusting the height of the stiffener 103 from the surface 1a, which may reduce an amount of the solder 3 overflowing to another pad, thereby effectively avoiding a short circuit between adjacent pads.

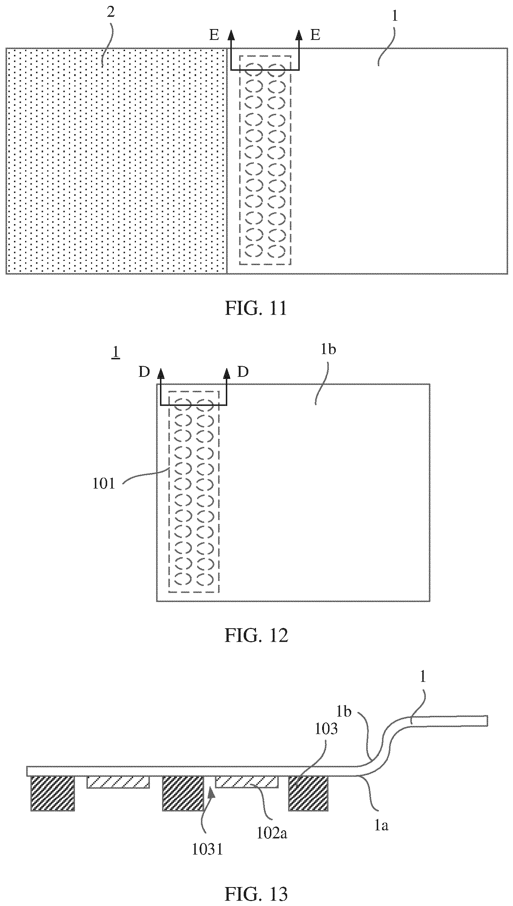

FIG. 11 is a schematic diagram of a structure of a circuit board assembly according to another possible embodiment of this application. In this embodiment, no first pad is disposed on a surface of the first circuit board 1. Specifically, when the first circuit board 1 is disposed, refer to FIG. 12. FIG. 12 is a schematic diagram of a structure of the first circuit board 1 of the circuit board assembly shown in FIG. 11. FIG. 12 shows a structure of the surface 1b of the first circuit board 1.

In addition, FIG. 13 is a sectional view of a D-D part in FIG. 12. In this embodiment, the surface 1a may be used as a first surface of the first circuit board 1, and the surface 1b may be used as a second surface of the first circuit board 1. At least two first pads 102a are disposed on the surface 1a of the first circuit board 1, and the at least two first pads 102a are located in the first soldering region 101 (not shown in FIG. 13, and reference may be made to FIG. 12) of the first circuit board 1. In addition, the stiffener 103 may also be disposed on the surface 1a, and the stiffener 103 may be provided with the first through holes 1031. The first pads 102a may be exposed from the first through holes 1031, to solder the first pads 102a to the second pads 202.

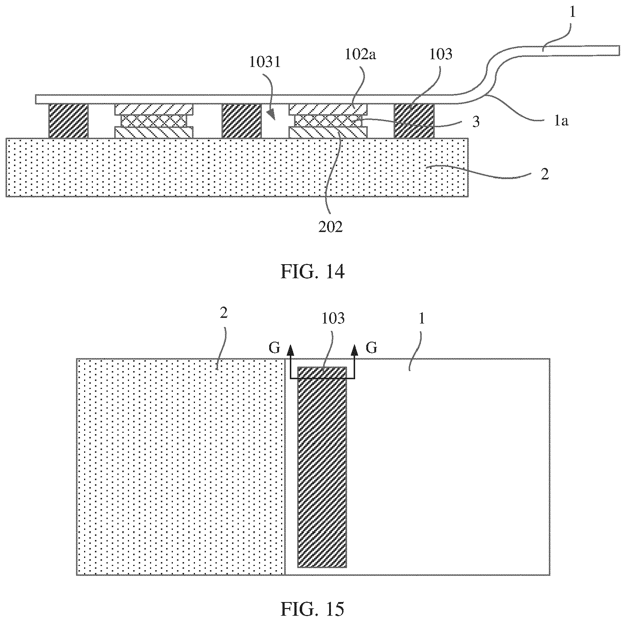

FIG. 14 is a sectional view of an E-E part in FIG. 11. In this embodiment, the surface 1a is disposed facing the second circuit board 2. According to a design solution of a circuit board assembly provided in this embodiment of this application, when the first circuit board 1 and the second circuit board 2 are soldered to each other, refer to the foregoing embodiments for a soldering process. Details are not described herein again. It should be noted that, in this embodiment, the stiffener 103 may be disposed to effectively improve structural strength and flatness of the first circuit board 1, so that the stiffener 103 may press the first pads 102a to the second pads 202, thereby improving reliability of a connection between the first circuit board 1 and the second circuit board 2. In addition, in the soldering process, in a process of soldering the first circuit board 1 to the second circuit board 2, the first circuit board 1 and another surface mount component may still be soldered to the second circuit board 2 by using a same process, which helps reduce processing processes of the circuit board assembly, improve processing efficiency, reduce processing costs, and implement a miniaturization design of the circuit board assembly.

In addition, in this embodiment, the height of the stiffener 103 from the surface 1a may be greater than the height of the first pad 102a, and the stiffener 103 may abut against the second circuit board 2, so that the stiffener 103 can support the first circuit board 1. In addition, because the stiffener 103 is disposed on the surface 1a, the hole wall of the first through holes 1031 of the stiffener 103 may block the overflow of the solder 3 on the surface 1a, thereby reducing the risk of the short circuit between the adjacent first pads 102a located on the surface 1a. In addition, the distance between the first pad 102a and the second pad 202 that are correspondingly disposed may be increased by adjusting the height of the stiffener 103 from the surface 1a, which may reduce the amount of the solder 3 overflowing to another pad, thereby effectively avoiding the short circuit between the adjacent pads.

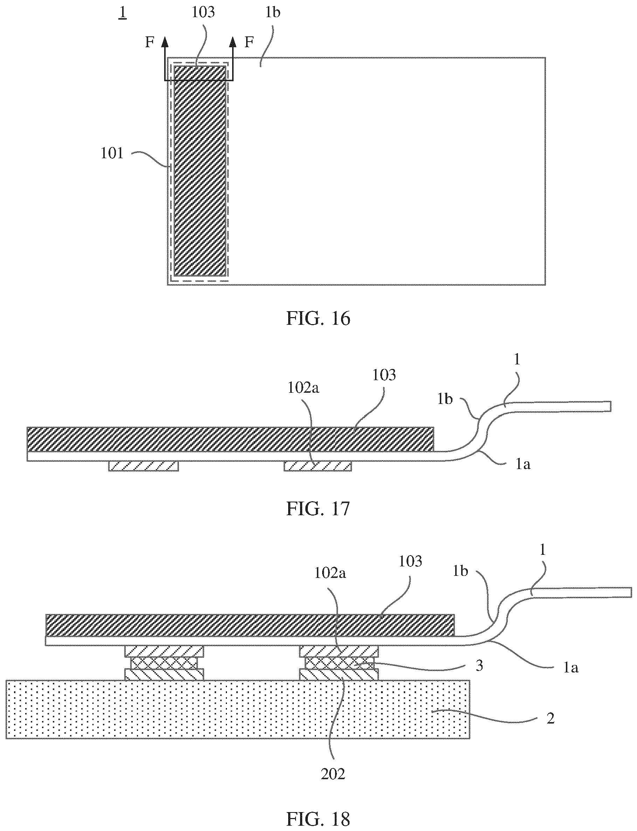

FIG. 15 is a schematic diagram of a structure of a circuit board assembly according to another possible embodiment of this application. In this embodiment, a structure of the first circuit board 1 is slightly different from that in the foregoing embodiments. Specifically, when the first circuit board 1 is disposed, refer to FIG. 16. FIG. 16 is a schematic diagram of a structure of the first circuit board 1 of the circuit board assembly shown in FIG. 15. FIG. 16 shows a structure of the surface 1b of the first circuit board 1. In this embodiment, the stiffener 103 is disposed on the surface 1b of the first circuit board 1.

FIG. 17 is a sectional view of an F-F part in FIG. 16. In this embodiment, the surface 1a may be used as a first surface of the first circuit board 1, and the surface 1b may be used as a second surface of the first circuit board 1. At least two first pads 102a are disposed on the surface 1a of the first circuit board 1, and the at least two first pads 102a are located in the first soldering region 101 (not shown in FIG. 17, and reference may be made to FIG. 16) of the first circuit board 1. In addition, the first pads 102b shown in FIG. 10 are not disposed on the surface 1b of the first circuit board 1, the stiffener 103 may be disposed on the surface 1b of the first circuit board 1, and the stiffener 103 is not provided with the first through holes 1031 shown in FIG. 10. The stiffener 103 may be a continuous and flat plate structure, thereby helping improve structural strength and flatness of a part that is of the first circuit board 1 and in which the stiffener 103 is disposed.

FIG. 18 is a sectional view of a G-G part in FIG. 15. According to a design solution of a circuit board assembly provided in this embodiment of this application, when the first circuit board 1 and the second circuit board 2 are soldered to each other, refer to the foregoing embodiments for a soldering process. Details are not described herein again. It should be noted that, in this embodiment, the stiffener 103 may be disposed to effectively improve structural strength and flatness of the first circuit board 1. Therefore, in a process of soldering the first circuit board to the second circuit board, the stiffener 103 may press the first pads 102a to the second pads 202, thereby improving reliability of a connection between the first circuit board 1 and the second circuit board 2. In addition, in the soldering process, the first circuit board 1 and another surface mount component may still be soldered to the second circuit board 2 by using a same process, which helps reduce processing processes of the circuit board assembly, improve processing efficiency, reduce processing costs, and implement a miniaturization design of the circuit board assembly.

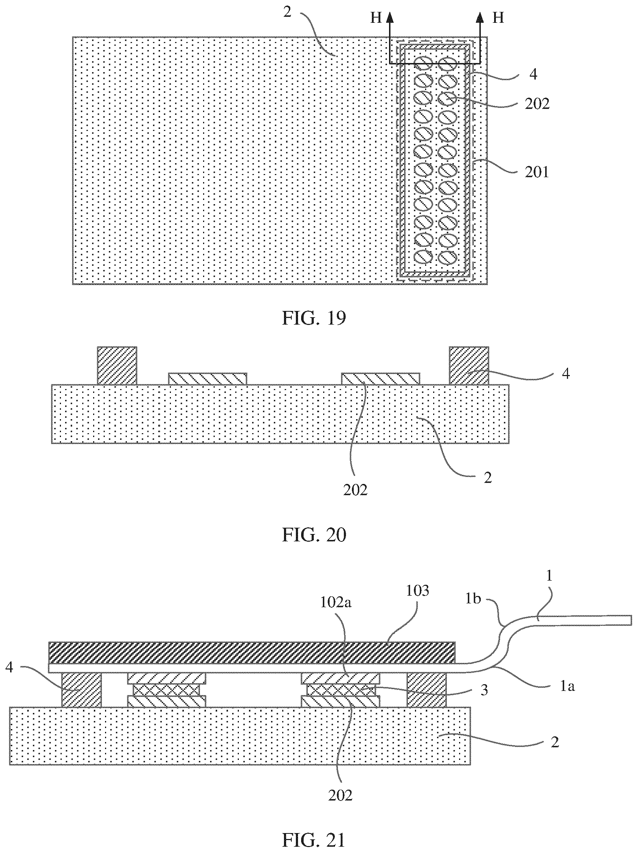

It can be learned from the description of the circuit board assembly provided in this application in the foregoing embodiments that, in the process of soldering the first circuit board 1 to the second circuit board 2, there may be a problem that a short circuit may be caused between adjacent pads by overflow of the solder 3. To resolve this problem, in addition to the solutions provided in the foregoing embodiments of this application, the circuit board assembly may be further disposed in another possible manner. For example, FIG. 19 is a schematic diagram of a structure of a second circuit board 2 according to a possible embodiment of this application. FIG. 19 shows a structure of a side surface that is of the second circuit board 2 and that is used for soldering to the first circuit board 1. In this embodiment, in addition to the second pads 202, a gasket 4 may further be disposed on the second circuit board 2. The gasket 4 and the second pads 202 are disposed on a same surface of the second circuit board 2.

FIG. 20 is a sectional view of an H-H part in FIG. 19. A height of the gasket 4 from a surface of the second circuit board 2 is greater than a height of the second pad 202 from the surface of the second circuit board 2. The gasket 4 may be an annular structure. For example, as shown in FIG. 19, at least one second pad 202 in the second soldering region 201 may be disposed in a closed region enclosed by the gasket 4. In some other possible embodiments of this application, the gasket 4 may be further divided into a plurality of segments for disposition. The plurality of segments of the gasket 4 may be distributed at any location in the second soldering region 201. For example, the plurality of segments of the gasket 4 may be distributed at corners of the second soldering region 201, or may be disposed at gaps between adjacent second pads 202.

FIG. 21 is a sectional view of a partial structure of a circuit board assembly according to this embodiment. In this embodiment, a structure of the first circuit board 1 may be disposed with reference to the embodiment shown in FIG. 17. The surface 1a may be used as a first surface of the first circuit board 1, and the surface 1b may be used as a second surface of the first circuit board. At least two first pads 102a are disposed on the surface 1a, the stiffener 103 may be disposed on the surface 1b of the first circuit board 1, and the stiffener 103 may be a continuous and flat plate structure, thereby helping improve structural strength and flatness of a region that is of the first circuit board 1 and in which the stiffener 103 is disposed.

In addition, it can be learned from FIG. 21 that the gasket 4 may abut against the surface 1a of the first circuit board 1. In this way, a distance between the first pad 102a and the second pad 202 that are correspondingly soldered to each other may be increased by adjusting the height of the gasket 4 from the surface of the second circuit board 2, so that in a process of soldering the first circuit board 1 to the second circuit board 2, an amount of the solder 3 that is between the first pads 102a and the second pads 202 and that overflows to another pad can be reduced, thereby effectively avoiding a short circuit between adjacent pads.

It may be understood that, in addition to being disposed on the second circuit board 2, the gasket 4 may also be disposed on the surface 1a of the first circuit board 1. For example, the gasket 4 may be disposed on the surface 1a of the first circuit board 1 shown in FIG. 4 or FIG. 17. For a specific disposition manner, refer to the description of the gasket 4 disposed on the second circuit board 2 in the foregoing embodiments. Details are not described herein again. For example, a height of the gasket 4 from the surface 1a may be greater than a height of the first pad 102a, provided that the gasket 4 can abut against the second circuit board 2, to support and avoid a short circuit between the first circuit board 1 and the second circuit board 2.

To reduce the solder 3 that is between the first pads 102a and the second pads 202 that are correspondingly soldered to each other and that overflows to another pad, in some other possible embodiments of this application, a solution of increasing a distance between the first circuit board 1 and the second circuit board 2 may be further used. During specific implementation, a height of the second pad 202 of the second circuit board 2 may be increased when the height of the first pad 102a of the first circuit board 1 and a height of the solder 3 remain unchanged. In this way, in a process soldering the corresponding first pads 102a to the corresponding second pads 202, the melted solder 3 may flow along a side wall of the second pads 202, to reduce an amount of the melted solder 3 overflowing to surroundings, thereby reducing a risk of a short circuit between pads. It should be noted that the solution provided in this embodiment may be implemented by increasing heights of all second pads 202 in the second soldering region 201 of the second circuit board 2, or may be implemented by increasing heights of some second pads 202, for example, increasing heights of second pads 202 located at corners.

In the foregoing embodiments of this application, for ease of description, a connection manner between circuit boards in the circuit board assembly is described by using the connection between the first circuit board 1 and the second circuit board 2 as an example. It may be understood that, when the circuit board assembly includes more than two circuit boards, a connection between any flexible printed circuit and a printed circuit board in the more than two circuit boards, and a connection between flexible printed circuits may be disposed with reference to any one of the foregoing embodiments. Details are not described herein, but it should be understood that the connection falls within the protection scope of this application.

Clearly, persons skilled in the art can make various modifications and variations to this application without departing from the spirit and scope of this application. This application is intended to cover these modifications and variations of this application provided that they fall within the scope of protection defined by the following claims and their equivalent technologies.

## Claims

1. A circuit board assembly, comprising a first circuit board and a second circuit board, wherein
the first circuit board is a flexible printed circuit, a stiffener and first pads are disposed on a first surface of the first circuit board, the stiffener is provided with first through holes, at least one first pad is located in the first through hole, and hardness of the stiffener is greater than hardness of the first circuit board; and
second pads are disposed on the second circuit board, and the at least one first pad is soldered to the second pad.

2. The circuit board assembly according to claim 1, wherein at least two first pads are disposed on a second surface that is of the first circuit board and that is disposed back to the first surface, and at least two first pads are disposed on the first surface; and
the at least two first pads on the first surface are disposed in a one-to-one correspondence with the at least two first pads on the second surface, and the first pads on the first surface and the first pads on the second surface that are correspondingly disposed are connected through second through holes.

3. The circuit board assembly according to claim 2, wherein the first surface is a surface that is of the first circuit board and that is opposite to the second circuit board.

4. The circuit board assembly according to claim 3, wherein the first pads in the first through holes are soldered to the second pads via a solder that passes through the second through holes.

5. The circuit board assembly according to claim 3 or 4, wherein the circuit board assembly further comprises a gasket, the gasket is located between the first circuit board and the second circuit board, and the gasket abuts against the first circuit board and the second circuit board.

6. The circuit board assembly according to claim 2, wherein the first surface is a surface that is of the first circuit board and that faces the second circuit board.

7. The circuit board assembly according to claim 6, wherein the stiffener abuts against the second circuit board.

8. The circuit board assembly according to any one of claims 1 to 7, wherein the at least two first pads are disposed on the first surface, the stiffener is provided with at least two first through holes, and each first pad is located in one first through hole in a one-to-one correspondence; or
the stiffener is provided with at least one first through hole, and the at least two first pads are located in one first through hole.

9. The circuit board assembly according to any one of claims 1 to 8, wherein a height of the stiffener from the first surface of the first circuit board is greater than or equal to a first height, and the first height is a height of the first pad disposed on a same surface as the stiffener from the first surface of the first circuit board.

10. The circuit board assembly according to claim 1, wherein the first surface is a surface that is of the first circuit board and that faces the second circuit board.

11. The circuit board assembly according to any one of claims 1 to 10, wherein a material of the stiffener is glass fiber, polyimide, or stainless steel.

12. A circuit board assembly, comprising a first circuit board, a second circuit board, and a gasket, wherein
the first circuit board is a flexible printed circuit, first pads are disposed on a first surface of the first circuit board, a stiffener is disposed on a second surface of the first circuit board, the first surface and the second surface are disposed back to each other, and hardness of the stiffener is greater than hardness of the first circuit board;
second pads are disposed on the second circuit board, and the first pads are soldered to the second pads, wherein the first pads and the second pads are correspondingly disposed; and
the gasket is located between the first circuit board and the second circuit board, and the gasket abuts against the first circuit board and the second circuit board.

13. The circuit board assembly according to claim 12, wherein the gasket is disposed on the second circuit board, and the second pads and the gasket are disposed on a same surface of the second circuit board; and a height of the gasket from the surface of the second circuit board is greater than a height of the second pad from the surface of the second circuit board.

14. The circuit board assembly according to claim 13, wherein the gasket is an annular structure, and at least one second pad in a second soldering region of the second circuit board is disposed in a closed region enclosed by the gasket; or the gasket has a plurality of segments, and the plurality of segments of the gasket are disposed at gaps between adjacent second pads or corners of the second soldering region.

15. The circuit board assembly according to claim 12, wherein the gasket is disposed on the first surface of the first circuit board, and a height of the gasket from the first surface is greater than a height of the first pad from the first surface.

16. A soldering method applied to the circuit board assembly according to any one of claims 1 to 15, wherein the soldering method comprises:
moving a first circuit board to a second circuit board, and disposing first pads corresponding to second pads; and
soldering the first pads to the second pads, wherein the first pads and the second pads are correspondingly disposed.

17. The soldering method according to claim 16, wherein the soldering the first pads to the second pads, wherein the first pads and the second pads are correspondingly disposed comprises:
soldering, by using reflow soldering, the first pads to the second pads, wherein the first pads and the second pads are correspondingly disposed.

18. The soldering method according to claim 16 or 17, wherein before the moving a first circuit board to a second circuit board, the method further comprises:
placing a solder on the second pads of the second circuit board.

19. An electronic device, comprising the circuit board assembly according to any one of claims 1 to 15.
